# EUROPÄISCHE PATENTSCHRIFT

(11) **EP 1 188 560 B1**
(45) Veröffentlichungstag und Bekanntmachung des Hinweises auf die Patenterteilung: **10.11.2004**
(21) Anmeldenummer: 01121878.1
(22) Anmeldetag: 12.09.2001
(51) Int. Cl.: B41C 1/10, B41M 5/40, B41M 5/38

(54) **Thermotransferfolie mit reaktiver Polymermasse zur laserinduzierten Bilderzeugung, Polymermasse ,Herstellungsverfahren der Folie, und Druckform**
Thermal transfer foil with reactive polymer composition for laser-induced imaging, composition,process for producing the foil and printing plate
Feuille ayant une composition d'un polymère réactif pour la formation d'images par transfert induit par laser,composition,méthode de fabrication de la feuille et plaque d'impression

(30) Priorität: 15.09.2000 DE 10045774
(43) Veröffentlichungstag der Anmeldung: 20.03.2002
(73) Patentinhaber: MAN Roland Druckmaschinen AG, 63012 Offenbach (DE)
(72) Erfinder: Schneider, Josef, Dr., 86420 Diedorf (DE); Hartmann, Thomas, Dr., 86356 Neusäss-Westheim (DE); Fuchs, Andrea, Dr., 86159 Augsburg (DE)
(74) Vertreter: Schober, Stefan, Dipl.-Ing.

(56) Entgegenhaltungen:
- EP-A- 0 787 777
- EP-A- 0 844 079
- EP-A- 1 075 963
- US-A- 5 188 665
- US-A- 5 238 778
- US-A- 5 494 774
- US-A- 5 716 217

## Beschreibung

Die Erfindung betrifft eine gattungsgemäße Thermotransferfolie mit einer reaktiven Polymermasse, die als Donorelement zur Bebilderung eines lithographischen Druckformzylinders, insbesondere zum Offsetdruck, durch laserinduzierte Übertragung geeignet ist. Die Erfindung betrifft außerdem ein Verfahren zur Herstellung der Folie sowie Zwischenprodukte dafür.

Bekannt ist ein Druckverfahren, bei dem ein Druckformzylinder punktförmig und bildmäßig mit Kunststoff versehen wird. Dieser Druckformzylinder wird dann für ein Offset-Verfahren mit Druckfarben beschichtet und die Druckfarbe der farbführenden Bereiche wird von einer Gummiwalze aufgenommen und auf das zu bedruckende Substrat übertragen. Für einen raschen Wechsel der Druckmotive, insbesondere für Kleinauflagen, ist es erwünscht, den Vorgang innerhalb einer Vorrichtung zum einen möglichst rechnergesteuert und zum anderen ohne Wechsel beweglicher Teile aufzuführen. Die in EP-B-0 698 488 vorgestellte Druckvorrichtung erfüllt diesen Bedarf.

Der in der vorstehend genannten Vorrichtung verwendete Druckformzylinder wird mit einem Polymer, das von einem Thermotransferband stammt, punktförmig und bildmäßig belegt. Zur Gewinnung einer für den Offsetdruck geeigneten lithographischen Druckform - das bedeutet auf dem Druckformzylinder deutliche Trennung der hydrophilen Bereiche (die nicht mit Polymer belegten Teile auf dem Druckformzylinder) und hydrophoben Bereiche (die mit Polymer belegten Teile auf dem Druckformzylinder, die später beim Druckvorgang die farbführenden Bereiche darstellen) - müssen bestimmte physikalische und chemische Parameter der Thermotransferfolie, insbesondere für ein Thermotransferband, eingestellt und optimiert werden.

EP-A-1 075 963 ein Dokument nach Art 54(3) EPÜ, betrifft eine Thermotransferfolie, die als Donorelement zur Bebilderung eines lithographischen Druckformzylinders, insbesondere zum Offsetdruck, durch laserinduzierte Übertragung geeignet ist. Das in der Donorschicht enthaltene Polymer, das saure Gruppen und/oder deren gegebenenfalls substituierte Amidgruppen umfasst, sich bei einem pH-Wert größer 10 in Wasser aber nicht im Feuchtwasser löst, enthält kein zugesetztes reaktionsfähiges Polymer in einer Menge von 1-20 %, bezogen auf den Gesamtpolymergehalt, und ausgewählt aus Epoxid, Isocyanat und/oder Polyvinylbutyral.

US-A-5 494 774 betrifft die Verwendung von thermischen Masse- und oder Farbstofftransfermechanismen von Donor- auf Rezeptorfolien oder -Platten bei der Herstellung von lithographischen Druckplatten. für die digitale Lithographie und schlägt ein thermisches Massetransfersystem vor, das ein im schwach alkalischem Milieu (pH etwa 7-10) lösliches Photopolymer enthält.

US-A-5 238 778 betrifft ein Verfahren zur Herstellung von Druckplatten durch Thermotransfer. D3 soll ein sehr verlässliches Verfahren bereitstellen, das Druckplatten mit guten Druckfarbenannahme und hoher Druckstandzeit, einem niedrigen Energieverbrauch und geringen Kosten liefert.

US-A-5 188 665 betrifft eine verbesserte schwarze Tintenformulierung auf Wasserbasis.

US-A-5 716 217 betrifft eine Tintenzusammensetzung auf Wasserbasis, die löschbare und lichtstreuende Schrift oder Markierung auf undurchdringbaren Oberflächen von transparenten Platten oder "Neon"tafeln, z.B. aus Glas oder Harz, erzeugt.

Aufgabe der vorliegenden Erfindung ist es, eine verbesserte Thermotransferfolie zur Bebilderung eines Druckformzylinders durch eine laserinduzierte Übertragung eines Polymers aus einer Donorschicht der Thermotransferfolie bereitzustellen, wobei die nachstehenden Erfordernisse zu beachten sind:
1. der Träger muß den mechanischen Anforderungen des Transports, den optischen Anforderungen des Durchtritts eines Laserstrahls und den thermischen Anforderungen bei der Erwärmung der aufgetragenen Beschichtung genügen;
2. die auf der Folie befindliche, punktweise und bildmäßig zu übertragende Beschichtung soll fest an dem Druckformzylinder haften und eine für eine möglichst hohe Auflage ausreichende Standzeit bei gleichbleibender Druckqualität bieten; und
3. die aufgetragene Polymerschicht auf dem Druckformzylinder sollte nach dem Druckvorgang in einfacher Weise umweltschonend und schnell entfernt werden können, damit alsbald ein neuer Druckvorgang beginnen kann.
4. Die pixelförmig aufgetragene Polymermasse soll eine ideale Zylinderform aufweisen oder sich dieser Form nähern.

Die vorstehende Aufgabe und weitere der nachstehenden Beschreibung zu entnehmende Aufgaben wurden durch den Gegenstand des Hauptanspruchs gelöst. Weitere besondere Ausführungsformen werden in den Unteransprüchen definiert.

Die erfindungsgemäße Thermotransferfolie besteht aus einer Substratschicht 1, z.B. eine Trägerfolie oder ein Trägerband, aus einem möglichst wärmebeständigen Kunststoff und darauf aufgetragen eine Donorschicht 2, d.h. die wärmeempfindliche übertragbare Schicht, wie im Hauptanspruch definiert. Durch Einwirkung des Laserstrahls 3 von der Rückseite des Thermotransferbands, d.h. von der im Sinne einer Donorschicht unbeschichteten Seite der Substratschicht 1 wird in der Donorschicht Wärme induziert, die zum Erweichen und schließlich zum Ablösen der Kunststoffschicht führt. Aufgrund von gasförmigen Stoffen, die insbesondere an der Grenzschicht 5 zwischen der Substratschicht 1 und der darauf aufgetragenen Donorschicht 2 entstehen, wird die wärmeempfindliche Donorschicht im weichen bis halbfesten Zustand bildmäßig aus dem Verbund der Substrat/Donorschicht herausgelöst und auf den Formzylinder übertragen. Zusätzlich wird durch die Art der Antragung des Bandes (siehe EP-B-0 698 488) der Transfervorgang unumkehrbar und gerichtet. Durch die enthaltenen reaktiven Polymere wird über die Wärmeeinwirkung des Laserstrahls eine sofortige Härtung ausgelöst. Der Kunststoff kühlt aufgrund der hohen Wärmekapazität des z.B. aus Metall bestehenden Zylinders sofort ab und haftet am Druckformzylinder. Nachdem der gesamte Druckformzylinder durch einen spiralförmigen Auftragungsvorgang in hoher Geschwindigkeit punktförmig und bildmäßig mit einer Kunststoffschicht versehen wurde, wird die übertragene Schicht im wesentlichen in zwei Schritten nachbehandelt, nämlich in einem ersten Schritt wird ein Fixierschritt vorgenommen, bei dem durch die Wärmeeinwirkung u.a. die Kunststoffschicht besser an dem Material der Druckform haftet und in einem zweiten Schritt, in dem hydrophiliert wird, d.h. es werden die auf dem Druckformzylinder freiliegenden Bereiche durchgehend hydrophiler gestaltet (hydrophiliert) und gleichzeitig wird das Profil, d.h. die Randschärfe, des übertragenen Polymers schärfer gestaltet. Hydrophilie bedeutet in dieser Anmeldung die Wasserfreundlichkeit als ein Maß für die Benetzung mit Wasser unter dynamischen Bedingungen.

Der Druckformzylinder weist in unbebildertem Zustand eine Oberfläche mit durchgehend hydrophilen Eigenschaften auf. Hierfür eignen sich beispielsweise plasma- oder flammgespritzte Keramiken bzw. Metalloberflächen, wie Chrom, Messing (Cu52-65% Zn48-35%, z.B. Boltomet L® Cu63Zn37) und Edelstähle im Sinne von hochlegierten Stählen (nach DIN17440: 1.43xx (xx=01, 10, ...), 1.4568, 1.44xx (xx=04, 35, 01 ...)) etc.

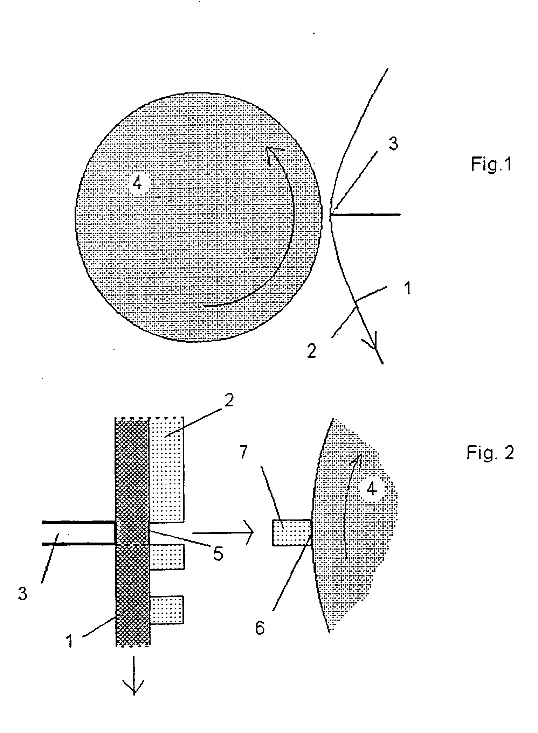

Figur 1 erläutert den Druckvorgang. Ein Laserstrahl 3 trifft auf die Rückseite 1 eines Thermotransferbandes oder einer Thermotransferfolie 1,2. Der Druckformzylinder dreht sich in der angegebenen Richtung. Der Druckformzylinder 4 wird spiralförmig mit Material der Donorschicht 2 bebildert.

Figur 2 erläutert den Übertragungsvorgang genauer. Aus dem Verbund der Donorschicht 2 werden nach Auftreffen des Laserstrahls 3 auf die Rückseite 1 des Thermotransferbandes (oder der Thermotransferfolie) Polymerteilchen 7 herausgelöst und haften auf dem Druckformzylinder 4. Die Vorgänge an der Grenzschicht 5 bzw. 6 werden in der Beschreibung genauer erläutert.

### Die Substratschicht

Die Substratschicht muß gegen mechanische Spannungen während des Laufes der Transportvorrichtung, z.B. der Bandstation und unter örtlichem Wärmeeinfluß beständig sein. Die Substratschicht muß darüber hinaus in bezug auf die bei der Herstellung des Thermotransferbands verwendeten Chemikalien chemisch inert sein. Vorzugsweise ist das Substrat für die zur Bilderzeugung verwendete Wellenlänge optisch durchlässig. Das Substrat sollte auch gegen elektrostatische Aufladung neutral sein, aber ein elektrischer Isolator sein.

Die Dicke der Substratschicht beträgt 50 µm bis 4µm oder bis 5 µm, insbesondere 12 bis 6 µm. Ein Optimum liegt bei 7,5 µm. Die die Dicke bestimmenden Parameter sind im wesentlichen die optische Transmission (Durchlässigkeit), die mechanische Festigkeit auch bei höherer Temperatur, die Wärmeleitfähigkeit und die thermische Stabilität und Maßhaltigkeit bei höherer Temperatur, wobei zwischen diesen Parametern ein Kompromiß zu suchen ist. Die optische Transmission steigt mit abnehmender Dicke der Substratschicht. Die mechanische Festigkeit wiederum verbessert sich mit steigender Dicke der Substratschicht. Der Wärmedurchtritt nimmt einerseits mit abnehmender Dicke zu. Andererseits erhöht sich die mechanische Stabilität mit zunehmender Dicke der Substratschicht.

Zum anderen sollte die Dicke der Substratschicht ausreichen, damit die bei Einwirkung eines Lasers mit einer Leistung von 300 mJ zur Übertragung von Material der Donorschicht notwendige Wärme erzeugt wird und somit eine wirksame Übertragung von Material der Donorschicht stattfindet.

Neben der Dicke spielt die Zugfestigkeit beim Bruch ebenfalls eine Rolle. Insbesondere sollte die Zugfestigkeit beim Bruch in Maschinenrichtung größer 200 N/mm², vorzugsweise größer 250 N/mm², besonders bevorzugt größer 270 N/mm², sein. Für die Querrichtung gilt größer 180 N/mm², bevorzugt größer 220 N/mm², insbesondere größer 270 N/mm². Die Zugfestigkeit wird im wesentlichen durch die mechanischen Beanspruchungen durch die Bandstation und - in Abhängigkeit von der Breite des Bandes - durch die örtliche Wärmeeinwirkung bestimmt.

Für die Genauigkeit der Erzeugung des Bildes auf dem Druckformzylinder ist unter anderem auch die Formstabilität der Substratschicht unter thermischer Belastung von Bedeutung. Bei einer thermischen Belastung von 150°C sollte die Schrumpfung kleiner 8 %, insbesondere kleiner 6,5 %, besonders bevorzugt kleiner 5 %, sein. Thermische Formstabilität der Substratschicht wird vor allem bei den nachstehenden Vorgängen gefordert:
a) bei der Herstellung, Lagerung und beim Transport,
b) bei der Haftung der Donorschicht auf der Substratschicht im Falle unterschiedlicher Ausdehnungskoeffizienten und Schichtdicken,
c) bei der Mehrfachnutzung des Bandes und der dabei geforderten räumlichen Präzision; darunter ist die Anordnung von mehreren dicht benachbarten Schreibspuren zu verstehen, wobei eine Schreibspur für den bildmäßigen Transfer benötigt wird. Die thermische Stabilität des Substrats garantiert im Falle der Mehrfachnutzung die Maßhaltigkeit des Bandes auch nach bereits erfolgten Transfervorgängen.

Das Substrat besteht vorzugsweise aus einem Kunststoff, der die vorstehend genannten mechanischen Eigenschaften auch bei einer Temperatur von 150°C oder größer noch aufweist. Daher kommen insbesondere optisch durchsichtige, wärmebeständige und hochfeste Kunststoffe in Betracht. Polypropylen sowie PVCP sind verwendbar. Insbesondere sind die verwendbaren Kunststoffe aber Polyester, Polyaryletheretherketone (PEEK), Polyphenylenether (PPE) und/oder Polycarbonate. Bevorzugt sind Polyester, unter ihnen sind Polyester bevorzugt, die von Dicarbonsäuren und Diolen und/oder von Hydroxycarbonsäuren oder den entsprechenden Lactonen abgeleitet sind, wie Polyethylenterephthalat, Polybutylenterephthalat, Poly-1,4-dimethylolcyclohexanterephthalat und Polyhydroxybenzoate sowie Block-Copolyether-Ester, abgeleitet von Polyethern mit Hydroxylendgruppen und auch Polyester, modifiziert mit Polycarbonaten. Geeignet sind auch Polyethylennaphthalindicarboxylate. Handelsübliche PET-Produkte sind z.B. Hostaphan® und Mylar®.

Vorzugsweise sollte der Kunststoff für die Substratschicht wenig, vorzugsweise keinen Weichmacher enthalten. Weichmacher sind im wesentlichen von niedermolekularer Natur und können daher bei der Umwandlung der Energie des Laserlichts in Wärme verdampfen und zu einem Plasmaeffekt führen. Auftretendes Plasma reflektiert den eindringenden Laserstrahl, so daß in der Donorschicht die zum Erweichen und Ausstoßen des zu übertragenden Materials erforderliche Wärme nicht mehr erreicht wird. Weichmacher, die bei Einwirkung eines Lasers mit einer Leistung von 300 mJ mit den vorstehend genannten Folien oder Bändern keinen Plasmaeffekt erzeugen, können toleriert werden. Das Gleiche gilt für Konzentrationen üblicher Weichmacher.

Für den als Substratschicht zu verwendenden Kunststoff ist eine möglichst hohe optische Transmission erwünscht. Die optische Transmission wird in der Regel durch die Dicke des Bandes und die Auswahl des Materials bestimmt. Außerdem ist die optische Transmission von der Wellenlänge abhängig. Im allgemeinen liegt der Wellenlängenbereich für IR-Halbleiterlaser zwischen 700 und 1600 nm. Vorzugsweise liegen die Bereiche bei 800 bis 900 nm, insbesondere 850 bis 820 nm einerseits und 1000 bis 1200 nm bzw. 1070 bis 1030 nm andererseits. Für einen Nd:YAG-Laser beträgt die Wellenlänge etwa 1064 nm. Die Transmission ist für die Substratschicht von >70% von IR-Licht im Wellenlängenbereich von 700 bis 1600 nm, bevorzugter >85%. Besonders bevorzugt ist eine Transmission von IR-Licht im Wellenlängenbereich von 800 bis 1100 nm von > 85%. Als Laser kann ein punktförmiger Laser verwendet werden. Bevorzugt sind allerdings IR-Halbleiterlaser-Diodenarrays.

Wie vorstehend erwähnt, muß das Substrat chemisch inert sein, d.h. die Chemikalien, die beim Herstellungsverfahren des Thermotransferbandes eingesetzt werden, dürfen das Substrat nicht nachteilig beeinflussen. lnsbesondere sind dies organische Lösemittel, vorzugsweise Ketone, aliphatische und cycloaliphatische Kohlenwasserstoffe sowie Säuren und Basen.

Wird eine Folie in Bandform verwendet, so beläuft sich die Breite des Bandes auf 3 mm bis 50 mm, vorzugsweise 8 mm bis 30 mm, bevorzugt 10 mm bis 15 mm.

### Der wärmeempfindliche und/oder laserempfindliche Stoff

Nachdem der Laserstrahl die Substratschicht durchdrungen hat, trifft er auf die Donorschicht, d.h. die Schicht mit der zu übertragenden Masse. An der Grenzschicht zwischen der Substratschicht und der Donorschicht soll in möglichst kurzer Zeit Lichtenergie in Wärmeenergie umgewandelt werden. Dazu ist es erforderlich, daß das zu übertragende Polymer einen Hilfsstoff enthält, der diesen Vorgang unterstützt. Insbesondere sind dies Stoffe, die die Energie der Lichtstrahlung insbesondere der vorgenannten Wellenlängenbereiche besonders gut absorbieren und in Wärmeenergie umwandeln. Diese Stoffe können organische Farbstoffe oder organische Färbemittel sein, unter der Maßgabe, daß sie sich bei Umwandlung von Lichtenergie in Wärmeenergie nicht zersetzen. Beispiele besonders stabiler organischer Farbstoffe oder Pigmente sind Benzothiazole, Chinoline, Cyaninfarbstoffe oder -pigmente, Perylenfarbstoffe oder -pigmente, Polymethinfarbstoffe und -pigmente, wie Oxonolfarbstoffe und -pigmente und Merocyaninfarbstoffe und -pigmente. Handelsübliche organische Farbstoffe oder Pigmente sind: KF 805 PINA von Riedl de Haen (eine Benzothiazolverbindung), KF 810 PINA von Riedl de Haen (eine Chinolinverbindung), ADS840MI, ADS840MT, ADS840AT, ADS890MC, ADS956BI, ADS800WS, ADS96HO von American Dye Source Inc., 3,3'-Diethylthiatricarbocyanin-p-toluolsulfonat (Cyaninfarbstoffverbindungen), Perylen-3,4,8,10-tetracarbonsäureanhydrid (eine Perylenverbindung) sowie Epolite V-63 und Epolite III-178 von Epolin Inc., Newmark. Die organischen Farbstoffe oder Pigmente werden in einer Menge von 5 bis 40 Gew.-%, vorzugsweise 10 bis 30 Gew.-%, der Trockenmasse der Donorschicht eingesetzt. Diese Farbstoffe können einzeln oder im Gemisch angewendet werden, um das Absorptionsmaximum in den Wellenlängenbereich des eingesetzten Lasers zu verschieben.

Neben organischen Farbstoffen oder organischen Färbemitteln sind anorganische Stoffe von Interesse, insbesondere jene, die sich bei der Umwandlung von Lichtenergie in Wärmeenergie nicht zersetzen. Derartige Stoffe sind beispielsweise Titandioxid, Aluminiumoxid und weitere Metalloxide und anorganische Farbpigmente. Zu nennen sind hier Magnetit: Fe₃O₄; Spinellschwarz: Cu(Cr,Fe)₂O₄, Co(Cr,Fe)₂O₄; Manganferrit: MnFe₂O₄. Diese Stoffe werden in einer Menge bis zu 20 Gew.-% eingesetzt.

Eine Sonderstellung für Stoffe, die effektiv Lichtenergie in Wärmeenergie umwandeln können, spielt Ruß. Durch das Herstellungsverfahren läßt sich Ruß besonders günstig beeinflussen. Insbesondere fein verteilter Ruß mit einer mittleren Teilchengröße zwischen 10 und 50 nm, insbesondere zwischen 13 und 30 nm und/oder mit einer Schwarzzahl nach DIN 55979 zwischen 200 und 290, insbesondere von 250, kann vorteilhaft eingesetzt werden. Ruße werden in einer Menge bis zu 30 Gew.-%, vorzugsweise bis zu 20 Gew.-%, eingesetzt. Die vorstehend genannten Stoffe, nämlich organische Farbstoffe oder Färbemittel, anorganischer Stoff, der sich bei der Umwandlung von Lichtenergie in Wärmeenergie nicht zersetzt, und Ruß können einzeln oder im Gemisch verwendet werden. Die Menge des wärmeempfindlichen und/oder laserlichtempfindlichen Stoffes hängt von der Fähigkeit der Umwandlung von Lichtenergie in ausreichend Wärmeenergie zur Übertragung des auf der Substratschicht befindlichen zu übertragenden Stoffes ab. Ein geeigneter Ruß ist Conductex.

### Das Polymer der Donorschicht

Das Polymer der Donorschicht übt insbesondere folgende Funktionen aus. Zum einen wird es unter Einwirkung des Laserstrahls rasch erweichen, an der Grenzfläche der Substratschicht den erforderlichen Druck entwickeln und als halbfester Pfropf auf den Druckformzylinder übertragen. Dort haftet der so übertragene Kunststoff aufgrund hydrophiler Gruppen an der hydrophilen Oberfläche des Druckformzylinders. Schließlich sollte das Polymer zunächst einen Fixierschritt durch Erwärmen und dann einen Hydrophilierungsschritt des fertigen Druckformzylinders überstehen. Bei diesem Schritt werden die freien Metallflächen des Druckformzylinders hydrophiliert und die Kunststoffbereiche auf dem Druckformzylinder profiliert. Außerdem sollte der nun auf dem Druckformzylinder befindliche Kunststoff, Druckfarbe annehmen können und eine möglichst hohe Standzeit aufweisen. Schließlich soll nach erfolgtem Druckvorgang in einfacher Weise umweltschonend, d.h. möglichst mit einer wässerigen nichttoxischen Lösung, die übertragene Masse von dem Druckformzylinder abgespült werden, so daß diese für den nächsten Vorgang in sehr kurzer Zeit wieder zur Verfügung steht. Aufgrund dieser Erfordernisse ergeben sich für das Polymer folgende Anforderungen. Die Polymere sind in wäßriger Lösung löslich, aber unlöslich in dem Feuchtwasser, das normalerweise beim Offset-Papierdruck verwendet wird. Dies wird dadurch erreicht, daß man das Polymer für einen vom Feuchtwasser abweichenden pH-Wert wasserlöslich gestaltet, nämlich einen pH-Wert größer 10, vorzugsweise 10,5, insbesondere größer 11.

Damit das Polymer von dem Substrat oder Träger 1 abgelöst werden kann, sollte sein Zahlenmittel des Molekulargewichts vorzugsweise 20000 nicht übersteigen. Andererseits sollte sein Zahlenmittel des Molekulargewichts vorzugsweise 1000 nicht unterschreiten, da sonst keine ausreichende Wasserbeständigkeit erreicht wird. Vorzugsweise liegt der Bereich zwischen 1000 und 15000, insbesondere zwischen 1000 und 10000.

Die Polymere müssen Druckfarbe annehmen. Hierfür ist eine Oberflächenspannung vorzugsweise zwischen 50 und 10 mN/m, insbesondere zwischen 40 und 23 mN/m, besonders bevorzugt im Bereich von 28 und 32 mN/m, von Bedeutung. Die Messung der Oberflächenspannung erfolgt über Randwinkelmessung mit 3 + n Testflüssigkeiten und wird nach Wendt, Own und Rabel ausgewertet.

Damit das übertragene Polymer an dem hydrophilen Druckformzylinder ausreichend haftet, weist es saure Gruppen auf. Diese Gruppen können ausgewählt sein aus den Gruppen -COOH, -SO₃H, -OSO₃H und -OPO₃H₂ sowie den gegebenenfalls Alkyl- oder Aryl-substituierten Amiden davon. Die Alkylgruppe kann 1 bis 6, vorzugsweise 1 bis 4, Kohlenstoffatome aufweisen, die Arylgruppe kann 6 bis 10, vorzugsweise 6, Kohlenstoffatome aufweisen. Vorzugsweise enthält das Polymer außerdem eine aromatische Gruppe. Bevorzugt sind Phenylgruppen. Das Polymer stammt vorzugsweise aus der Polymerisation von α,β-ungesättigten Carbon-, Sulfon-, Schwefel- und Phosphorsäuren oder -estern oder deren vorstehend definierten Amiden und Styrol sowie dessen Derivaten und gegebenenfalls α,β-ungesättigten Carbonsäureestern. Die Auswahl der sauren Monomere sowie der aromatisch vinylischen Monomere sollte so erfolgen, daß das Polymer eine Glasübergangstemperatur T_{g} zwischen 30 und 100°C, insbesondere 30 und 90°C, vorzugsweise zwischen 55 und 65°C, aufweist. Das Polymer weist vorzugsweise eine Ceiling-Temperatur im Bereich des Schmelzpunkts auf, wobei der Schmelzbereich zwischen 80 und 150, insbesondere 90 und 140, vorzugsweise 105 bis 115°C, besonders bevorzugt um 110°C, liegt. Als wenig vorteilhaft erwiesen sich Copolymerisate, die wesentliche Anteile an α-Methylstyrol enthielten.

Geignete Polymere findet man in US-A-4 013 607, US-A-4 414 370 sowie in US-A-4 529 787. Dort offenbarte Harze können z.B. im wesentlichen vollständig gelöst werden, wenn ein ausreichender Teil, beispielsweise 80-90 %, dieser Gruppen mit einer wäßrigen Lösung basischer Stoffe, wie Borax, Amine, Ammoniumhydroxid, NaOH und/oder KOH neutralisiert wird. Z.B. würde ein Styrol-Acrylsäure-Harz mit einer Säurezahl von etwa 190 nicht weniger als etwa 0,0034 Äquivalente -COOH - Gruppen pro Gramm Harz enthalten und würde im wesentlichen vollständig gelöst werden, wenn ein Minimum von etwa 80-90 % der -COOH - Gruppen durch eine wäßrige alkalische Lösung neutralisiert werden. Die Säurezahl kann im Bereich zwischen 120 und 550, 150 und 300, z.B. 150 bis 250 liegen. Die nachstehend angeführten Kombinationen von Monomeren sind bevorzugt: Styrol-Acrylsäure, Styrol-Maleinsäureanhydrid, Methylmethacrylat-Butylacrylat-Methacrylsäure, α-Methylstyrol/Styrol-Ethylacrylat-Acrylsäure, Styrol-Butylacrylat-Acrylsäure, Styrol-Methylacrylat-Butylacrylat-Methylacrylsäure. Ein alkalilösliches Harz mit 68 % Styrol/ 32 % Acrylsäure mit einem Molekulargewicht von 500-10000 kann erwähnt werden. Andere Harze weisen eine Säurezahl von etwa 200 und ein Molekulargewicht von etwa 1400 auf. Im allgemeinen weisen Styrol(α-Methylstyrol)-Acrylsäure-(Acrylsäureester)-Harze ein zahlenmittleres Molekulargewicht von 2500-4500 und ein gewichtsmittleres Molekulargewicht von 6500-9500 auf. Die Säurezahl liegt bei 170-200. Beispielhafte Polymere weisen 60-80 Gew.-% aromatische Monoalkenylmonomere und 40-20 Gew.-% (Meth)acrylsäuremonomere und gegebenenfalls 0-20 Gew.-% keine Carboxylgruppen enthaltendes Acrylmonomer auf. Gemische von 10:1 bis 1:2 oder 1:1, vorzugsweise 8:1 bis 1:2, zum Beispiel 2:1 bis 1:2 Styrol/α-Methylstyrol können eingesetzt werden. Als wenig vorteilhaft erwiesen sich allerdings Copolymerisate, die wesentliche Anteile an α-Methylstyrol enthielten.

Zur Lösung der vorstehend angeführten Teilaufgabe 4 werden dem vorstehend angeführten Polymer 1-20 %, vorzugsweise 7-12 % (bezogen auf den Gesamtpolymergehalt) reaktionsfähiges, vorzugsweise festes Polymer zugesetzt, ausgewählt aus Epoxid, Isocyanat oder Polyvinylbutyral.

Beispiele für Epoxide sind: Festharze auf der Basis von Bisphenol A, wie Araldit GT 6099, Araldit GT 7071 und Araldit GT 7072. Araldit® ist eine Handelsmarke von Ciba-Geigy für *Epoxidharze, Gieß- und Imprägnierharze in der Elektrotechnik, Harze für den Oberflächenschutz und Elektronik, Laminierharze, Preßmassen, Klebstoffe sowie Modell- u. Werkzeugharze. Als Epoxidharze bezeichnet man organische Verbindungen mit mehr als einer Epoxidgruppe (IUPAC: Oxirangruppe) pro Molekül, die zur Gewinnung von Polymeren eingesetzt werden. Es sind durchweg niedermolekulare oder oligomere Verbindungen.

Der Aufbau von Polymeren nach dem Epoxidharz-Polyadditionsverfahren basiert auf dem charakteristischen Verhalten der Epoxidgruppen, mit entsprechenden Reaktionspartnern unter Addition zu reagieren. Dabei müssen die Di-, Tri- und Tetraepoxidverbindungen (=Epoxidharze) und die Vernetzungskomponenten (=Härter) bezüglich Reaktivität und Funktionalität aufeinander abgestimmt sein.

Epoxidharze können aber auch direkt, durch Polymerisation der E-poyidgruppen, vernetzt werden.

Epoxid-Systeme (Harz/Härter-Kombinationen) werden vornehmlich zur Erzeugung vernetzter Polymere verwendet. Beim Einsatz von Diepoxidverbindungen mit bifunktionellen Additionskomponenten können lineare, bei Zusatz geringer Mengen trifunktioneller Komponenten auch verzweigte lösliche Strukturen gewonnen werden.

Durch die zahlreichen Möglichkeiten zur Kombination von Harz- und Härterstrukturen eignen sich Epoxidharzsysteme vorzüglich zur gezielten Einstellung von Werkstoffeigenschaften: einerseits, was die Viskosität und das rheologische Verhalten beim Verarbeitungsprozeß, andererseits, was die Eigenschaften der angestrebten Endprodukte betrifft. Zudem können durch zielgerichtete Zugabe oder Einarbeitung von Hilfsstoffen, wie Füllstoffen, Verstärkungsmaterialien, Flammschutzmitteln, Flexibilisatoren, Pigmenten und anderen, die Einsatzmöglichkeiten wesentlich erweitert werden.

Im Gegensatz zu den löslichen und in der Wärme schmelzbaren und verarbeitbaren Thermoplasten sind vernetzte Epoxidharze thermisch nicht mehr verformbar.

Beispiele für feste Epoxidharze sind:

| Bezeichnung | Epoxidgehalt (Äqu/kg) | Epoxidequivalentmasse (g/Äqu) | Molmasse | Erweichungstem peratur nach DIN 51920 (°C) | Viskosität bei 25°C nach DIN 53015 (mPa·s) |
|---|---|---|---|---|---|
| halbfest | 3,70 bis 4,35 | 230 bis 270 | ∼450 | - | 450 bis 700¹⁾ |
| fest, Typ 1 | 1,80 bis 2,25 | 450 bis 550 | ∼900 | 70 bis 80 | 160 bis 250²⁾ |
| fest, Typ 2 | 1,45 bis 1,80 | 550 bis 700 | ∼1100 | 80 bis 90 | 280 bis 350²⁾ |
| fest, Typ 4 | 1,05 bis 1,25 | 800 bis 950 | ∼1500 | 95 bis 105 | 450 bis 600²⁾ |
| fest, Typ 7 | 0,40 bis 0,62 | 1600 bis 2500 | ∼3000 | 120 bis 140 | 1500 bis 3000²⁾ |
| fest, Typ 9 | 0,25 bis 0,40 | 2500 bis 4000 | ∼4000 | 140 bis 160 | 3500 bis 10000²⁾ |
| fest, Typ 10 | 0,16 bis 0,25 | 4000 bis 6000 | ∼5000 | 150 bis 180 | 5000 bis 40000²⁾ |

| | | | | | |
|---|---|---|---|---|---|
| 1) 70 % in Butyldiglycol (Diethylenglycolmonobutylether) | | | | | |
| 2) 40 % in Butyldiglycol | | | | | |

Handelsprodukte sind jene der Araldit-(Ciba-Geigy), Beckopox- (Hoechst), D.E.R.-(Dow), Epikote-(Shell), Epodil-(Anchor), Eponac-(AMC Sprea Resine), Epotuf-(Reichhold), Eurepox-(Witco), Grilonit-(Ems-Chemie), Kelpoxy- (Reichold), Resox-(Synthopol), Rütapox-(Bakelite) und Ucar Phenoxy Resin- (Union Carbide)-Reihen.

Beispiele für Isocyanate sind:

Festharze blockierter Isocyanate, wie Crelan VP LS 2147 (Polyester mit Uretdiongruppen), Crelan VP LS 2292 (Dimethylpyrrol-blockiertes IPDI), Vestanat B 1358/100 (2-Butanonoxim-blockiertes IPDI), Desmodur IL oder Desmodur H. Crelan® dient u.a. als Bindemittel und Vernetzer auf der Basis von Polyestern bzw. Polyacrylaten in Kombination mit verkappten Isocyanaten zur Herstellung versprühbarer Pulverlacke. Hersteller ist die Bayer AG. Der Vernetzer Crelan® VP LS 2147 ist ein abspalterfreier Polyurethanlackhärter. Crelan VP LS 2147 basiert auf der Uretdionchemie. Durch Dimerisierung mittels geeigneter Katalysatoren lassen sich die Isocyanatgruppen reversibel desaktivieren. Erst bei höheren Temperaturen werden die Isocyanatfunktionen wieder freigesetzt, die dann emissionsfrei abreagieren können. Im Gegensatz zu Systemen, in denen Caprolactam-blockierte Polyisocyanate für die Vernetzung verwendet werden, verursacht dieser Uretdionhärter keine Emission von Blockierungsmitteln und spaltet bei der Vernetzungsreaktion auch kein Wasser ab. Der Härter ist toxikologisch unbedenklich und daher nicht kennzeichnungspflichtig.

Polyvinylbuyrale, worin R= -CH₂-CH₂-CH₂-CH₃ in der Formel 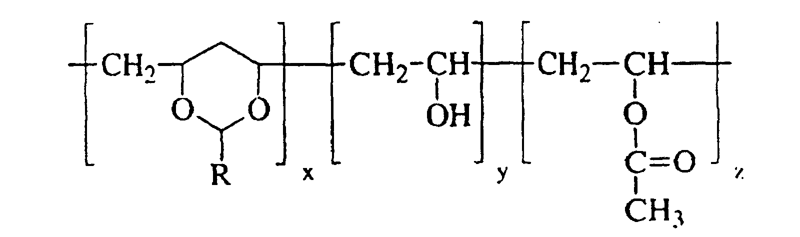 haben im Vergleich zu Polyvinylformal geringere Festigkeiten, sie sind weicher und dehnbarer. Sie sind in niederen Alkoholen, Glycolethern und Alkohol-Aromatengemischen löslich, in Reinaliphaten unlöslich. Polyvinylbutryrale bestehen sowohl aus hydrophoben als auch aus hydrophilen Monomerbausteinen. Während die hydrophoben Vinylbutyral-Einheiten eine thermoplastische Verarbeitbarkeit, Löslichkeit in vielen Lösungsmitteln, Verträglichkeit mit anderen Polymeren und Weichmachern und gute mechanische Eigenschaften bewirken, sind die Vinylalkohol-Einheiten für die gute Haftung auf Glas, Holz und Metallen, die hohe Festigkeit, das hohe Pigmentbindevermögen und die Vernetzbarkeit verantwortlich. Mit steigendem Vinylalkoholgehalt nimmt die Festigkeit und der Elastizitätsmodul sowie die Glastemperatur zu. Der Anteil an Vinylalkoholeinheiten liegt zwischen 15 bis 30 Masseprozent, der an Vinylacetateinheiten zwischen 1 bis 3 Massenprozent. Handelsprodukte aus Polyvinylbutyral sind z.B.: Butvar (Monsanto), Denka Butyral (Denki Kagaku), Mowital (Hoechst), Pioloform (Wacker), Rhovinal (Rhone Poulenc), S-Lec-B (Sekisui) und Vinylite (Union Carbide).

Der Polymermasse können, bezogen auf das Gesamtgewicht, vorzugsweise 1-20 %, bevorzugter 7-12 % eines einwertigen C₁-C₂₀-Alkanols, vorzugsweise eines C₃-C₁₈-Alkanols, und/oder eines mehrwertigen C₃-C₁₂-Alkanols (wie Glycerin, Propandiol, Ethoxy(ethoxy)ethanol, Cellosolv oder Carbitol) einer Tetrose, Pentose oder Hexose (wie Erythrit, Arabinose, Glucose), eines hydrierten Derivats davon wie (wie Sorbit, Arabit oder Mannit) oder Benzoat zugesetzt werden.

Das für das Verfahren verwendete Thermotransferband weist ein Beschichtungsgewicht im Bereich von 0,8 bis 5 g/m² +/- 0,2 auf und bevorzugt liegt dieses im Bereich von 1,6 bis 2,0 g/m².

### Die Benetzungshilfe

Der Benetzungshilfe kommen verschiedene Funktionen zu. Die Benetzungshilfe liegt nach dem Übertragen auch am Grenzbereich zwischen Metalloberfläche und übertragenem Polymer vor, so daß dort die Haftung erhöht wird. Schließlich glättet sie beim Fixieren, d.h. bei einem nachträglichen Erwärmen des übertragenen Polymers, die Oberfläche des übertragenen Polymers, so daß die Struktur des Bildpunktes verbessert wird. Die Benetzungshilfe wird ausgewählt aus Lösemitteln, wie Alkohole, Ketone, Ester der Phosphorsäure, Glykolether und anionische Tenside, insbesondere Alkohole und Ketone, bevorzugt Ketone, besonders bevorzugt Methylethylketon. Handelsprodukte der vorgenannten Lösemittel sind DEGDEE, DEGBBE von BASF als Vertreter der Glykolether und Arylalkylsulfonsäuren als Vertreter der anionischen Tenside oder aliphatische Ester von Orthophosphorsäure, wie Etingal. Vorzugsweise stammen die als Benetzungshilfe dienenden Lösemittel aus dem Herstellungsschritt des Thermotransferbandes.

Benetzungshilfen können in geringen Mengen (z.B. 0,05-8 Gew.-%, vorzugsweise 0,5-5 Gew.-% der Trockenmasse der Donorschicht) durch den Herstellungsvorgang eingebracht werden. Ein weiterer Vorteil des Vorliegens einer Benetzungshilfe ist eine intrinsische Temperaturregelung beim Transfervorgang und bei der thermischen Nachbehandlung. Über die Eigenschaften Siedepunkt, -bereich, Verdampfungsenthalpie und Wärmekapazität wird bei beiden Vorgängen für das nötige Zeitfenster eine maximale obere Grenztemperatur definiert. Beispielsweise können mikroskopische Desorptionsvorgänge im Falle einer auf Ruß basierenden Formulierung eine obere Grenztemperatur vorgeben. Eine Überhitzung der übertragenen Masse kann sowohl durch die externe Regelung der Wärmequellen als auch durch die Zusammensetzung der Masse selbst beeinflußt werden und schafft damit eine hohe Sicherheit bei der Verfahrensführung.

### Das Verfahren

Die Herstellung des Thermotransferbandes erfolgt in üblicher Weise. Insbesondere werden der wärmeempfindliche oder laserlichtempfindliche Stoff, das Polymer und gegebenenfalls eine Benetzungshilfe sowie ein Lösemittel, wobei letztere identisch sein können, sorgfältig und homogen vermischt. Die Masse wird dann mit einem Meyer-Bar oder nach dem Gravurverfahren aufgetragen. Die Dicke der Übertragungsschicht beträgt 0,5 bis 5 µm, vorzugsweise 0,8 bis 4 µm, insbesondere 1 bis 3 µm, bevorzugt 1,5 bis 2,5 µm, Trockenschichtdicke. Nach dem Verdampfen des Lösemittels wird das Band auf eine Spule gewickelt und in eine Bandstation eingesetzt.

### Die Funktion der erfindungsgemäßen Thermotransferfolie

Die Bildpunktübertragungseinheit (ein punktförmiger Laser oder ein Halbleiterlaserdiodenarray) empfängt von einem Datenspeicher Daten für die Bebilderung des Druckformzylinders. Das Thermotransferband bewegt sich mit Hilfe einer Bandstation relativ zu einem während des Übergangsvorgangs sich selbst aber unabhängig bewegenden Druckzylinder. Diese Relativgeschwindigkeit und die zeitliche Abfolge der Daten steuert die Abbildung auf dem Druckzylinder. Die eingestrahlte Lichtenergie wird in Wärmeenergie umgewandelt, welche an der Grenzschicht zwischen Substratschicht und Donorschicht des Thermotransferbandes einen besonders starken Temperaturanstieg verursacht. Durch diesen Temperaturanstieg werden an der vorstehend genannten Grenzschicht Gase erzeugt, die das nun erweichte Material der Donorschicht gegen das Metall des Druckformzylinders schleudern. Die Substanzteile des übertragenen Materials markieren auf der Oberfläche des Druckformzylinders aufgrund ihrer oleophilen Eigenschaft beim späteren Druck die farbführenden Bereiche.

### Meßverfahren

a) Das Verhalten eines Polymers der Donorschicht in wässriger alkalischer Lösung wird durch nachstehendes Untersuchungsverfahren charaktersiert:
1g Polymer wird in einer wässrigen alkalischen Lösung gelöst. Zum Lösen werden die in der Tabelle aufgeführten Mengen an Lauge benötigt:

| | Lauge in g bis zum vollständigen Auflösen | pH-Wert |
|---|---|---|
| Polymer in 0,5 mol/l KOH | 10 | 13 |
| Polymer in 0,1 mol/l NaOH | 50 | 11 |
| Polymer in 0,3 mol/l NaOH | 20 | 13 |

In der vorliegenden Tabelle wurde das Polymer J682 der Fa. Johnson S.A. Polymer eingesetzt.
b) Die Randwinkelmessung erfolgt mit 3+n Testflüssigkeiten. Die Auswertung wird dann nach Wendt, Own und Rabel vorgenommen. Erhalten wird die statische Oberflächenspannung.
c) Die Messung der Glasübergangstemperatur, des Schmelzbereichs und die Bestimmung der Ceiling-Temperatur wurde mit einem DSC-Gerät der Fa. Mettler Toledo, DSC30/TSC10A/TC15 mit einem 150 µl-Aluminiumbecher, der 20-30 mg Polymer enthält, ausgeführt. Eine Temperaturrate von 10-20°C/min wurde verwendet. Folgendes Temperaturprogramm wurde genutzt: Beginn bei mindestens 70 Grad unter der zu erwartenden Tg und Ende bei etwa 50 Grad oberhalb der zu erwartenden Tg oder bei 180°C, um Zersetzung zu verhindern.

Die vorliegende Erfindung wird durch das nachstehende Beispiel genauer erläutert. Prozent-, Verhältnis- und Teilangaben sind auf das Gewicht bezogen, sofern nicht anders ausgewiesen.

### Beispiel 1 (nicht gemäß der Erfindung)

Eine Polyethylenterephthalatfolie (PET) Hostaphan® der Fa. Hoechst mit einer Dicke von 7,5 µm wird mit einem Meyer-Bar mit einer Masse nachstehender Zusammensetzung zu einem Trockenschichtgewicht von 1,8 g/m² beschichtet.

20 % Ruß mit einer Schwarzzahl nach DIN 55797 von 250 und 80 % Polymer J682 von Johnson S.A. Polymer und eine zur Herstellung einer streichfähigen Masse ausreichende Menge Methylethylketon werden angemischt. Die Masse wird mit einem Meyer-Bar zu dem vorstehend genannten Trockenschichtgewicht auf die Polyesterfolie aufgetragen. Nach dem Auftragen wird die Folie getrocknet. Im Falle eines Bandes mit einer Breite von beispielsweise 12 mm wird dieses auf eine Spule gewickelt und in eine Bandstation, z.B. eine Vorrichtung wie in EP-B-0 698 488 beschrieben, eingesetzt. Mit einem IR-Halbleiterlaserarray wird die Rückseite des so hergestellten Thermotransferbandes bestrahlt. Dabei werden gleichzeitig mehrere Kunststoffteilchen von dem Thermotransferband auf den Druckformzylinder bildmäßig übertragen. Mit dem so bebilderten Druckzylinder konnten 20 000 Exemplare bedruckt werden.

### Beispiel 2

Eine Polyethylenterephthalatfolie (PET) Hostaphan® der Fa. Hoechst mit einer Dicke von 7,5 µm wird mit einem Meyer-Bar mit einer Masse nachstehender Zusammensetzung zu einem Trockenschichtgewicht von 1,8 g/m² beschichtet.

4,52 g Conductex mit einer Schwarzzahl nach DIN 55797 von 250 und 13,19 g Polymer J682 von Johnson S.A. Polymer, 2,39 g Crelan VP LS 2147, 0,54 g Triton X200, 0,22 g Phosphorsäure (85 %ig) und 79,47 g Methylethylketon werden angemischt. Die Masse wird mit einem Meyer-Bar zu dem vorstehend genannten Trockenschichtgewicht auf die Polyesterfolie aufgetragen. Nach dem Auftragen wird die Folie getrocknet. Im Falle eines Bandes mit einer Breite von beispielsweise 12 mm wird dieses auf eine Spule gewickelt und in eine Bandstation, z.B. eine Vorrichtung wie in EP-B-0 698 488 beschrieben, eingesetzt. Mit einem IR-Halbleiterlaserarray wird die Rückseite des so hergestellten Thermotransferbandes bestrahlt. Dabei werden gleichzeitig mehrere Kunststoffteilchen von dem Thermotransferband auf den Druckformzylinder bildmäßig übertragen. Mit dem so bebilderten Druckzylinder konnten 20 000 Exemplare bedruckt werden.

## Patentansprüche

1. Thermotransferfolie, umfassend eine Substratschicht und darauf aufgetragen eine Donorschicht, **dadurch gekennzeichnet, daß**
a) die Substratschicht aus mindestens einer Polymermasse besteht, die mindestens die nachstehenden Eigenschaften aufweist:
mechanische Stabilität bei einer Temperatur >150°C; Transmission > 70 % für Licht der Wellenlänge von 700 bis 1600 nm, wobei die Substratschicht eine Dicke von 50 µm bis 4 µm, eine Zugfestigkeit beim Bruch größer 200 N/mm² in Maschinenrichtung und größer 180 N/mm² in Querrichtung und eine thermische Schrumpfung bei 150°C kleiner 8 % aufweist;
b) die Donorschicht mindestens folgende Komponenten umfaßt:
i) einen Stoff, der die Strahlungsenergie von auftreffendem Laserlicht in Wärmeenergie umwandeln kann,
ii) ein Polymer, das saure Gruppen und/oder deren gegebenenfalls substituierte Amidgruppen umfasst, sich bei einem pH-Wert größer 10 in Wasser aber nicht im Feuchtwasser, das normalerweise beim Offset-Papierdruck verwendet wird löst, wobei dem Polymer 1-20 % reaktionsfähiges Polymer, bezogen auf den Gesamtpolymergehalt, ausgewählt aus Epoxid, Isocyanat und/oder Polyvinylbutyral, zugesetzt wurden und
iii) gegebenenfalls eine Benetzungshilfe.

2. Thermotransferfolie nach Anspruch 1, wobei die Substratschicht eine Zugfestigkeit beim Bruch größer 270 N/mm² in Maschinenrichtung und eine thermische Schrumpfung bei 150°C kleiner 5 % aufweist.

3. Thermotransferfolie nach Anspruch 1 oder Anspruch 2, wobei die Polymermasse ein Polyester, Polyaryletheretherketon, Polyphenylenether und/oder ein Polycarbonat ist.

4. Thermotransferfolie nach Anspruch 3, wobei der Polyester aus Polyestern, die von Dicarbonsäuren und Diolen und/oder von Hydroxycarbonsäuren oder den entsprechenden Lactonen abgeleitet sind; wie Polyethylenterephthalat, Polybutylenterephthalat, Poly-1,4-dimethylolcyclo-hexanterephthalat, Polyhydroxybenzoate und Polyethylennaphthalindicarboxylate; sowie Block-Copolyether-Estern, abgeleitet von Polyethern mit Hydroxylendgruppen und Polyestern, modifiziert mit Polycarbonaten, ausgewählt ist.

5. Thermotransferfolie nach Anspruch 4, wobei der Polyester ein Polyethylenterephthalat ist.

6. Thermotransferfolie nach einem der Ansprüche 1 bis 5, wobei die Komponente i)
a) ein organischer Farbstoff oder ein organisches Färbemittel mit mindestens den nachstehenden Eigenschaften ist:
aa) Absorptionsmaximum im Wellenlängenbereich von 700 bis 1600 nm,
ab) eine Wärmebeständigkeit größer 150°C und/oder
b) ein anorganischer Stoff ist, der Strahlungsenergie in Wärmeenergie umwandeln kann, ohne sich zu zersetzen,
und/oder
c) eine Kohlenstoffart ist.

7. Thermotransferfolie nach Anspruch 6, wobei der organische Farbstoff oder das organische Färbemittel wärmestabile organische Farbstoffe oder Pigmente umfaßt, ausgewählt aus Benzothiazolen, Chinolinen, Cyaninfarbstoffen oder -pigmenten, Perylenfarbstoffen oder -pigmenten und Polymethinfarbstoffen oder -pigmenten, wie Oxonolfarbstoffe und -pigmente oder Merocyaninfarbstoffe und -pigmente.

8. Thermotransferfolie nach Anspruch 6, wobei der anorganische Farbstoff oder das anorganische Pigment ausgewählt ist aus TiO₂, Al₂O₃, Magnetit Fe₃O₄; Spinellschwarz: Cu(Cr,Fe)₂O₄, Co(Cr,Fe)₂O₄ und Manganferrit MnFe₂O₄.

9. Thermotransferfolie nach Anspruch 6, wobei der Kohlenstoff ausgewählt ist aus einem Ruß mit einer mittleren Teilchengröße von 5 bis 100 nm.

10. Thermotransferfolie nach Anspruch 9, wobei der Ruß eine Schwarzzahl nach DIN 55979 zwischen 200 und 290 aufweist.

11. Thermotransferfolie nach einem der Ansprüche 1 bis 10, wobei das Polymer ii) saure Gruppen, ausgewählt aus -COOH, -SO₃H, -OSO₃H und -OPO₃H₂ und/oder gegebenenfalls den mit C₁-C₆-Alkyl- oder C₆-C₁₀-Arylresten substituierten Amidgruppen davon, aufweist.

12. Thermotransferfolie nach einem der Ansprüche 1 bis 11, wobei das Polymer ein Zahlenmittel des Molekulargewichts von 1000 bis 20000 aufweist.

13. Thermotransferfolie nach einem der Ansprüche 1 bis 12, wobei das aufgetragene Polymer eine Oberflächenspannung von 50 bis 20 mN/m, ermittelt durch Randwinkelmessung, aufweist.

14. Thermotransferfolie nach einem der Ansprüche 1 bis 13, wobei das Polymer eine Glasübergangstemperatur im Bereich von 30 bis 100°C aufweist.

15. Thermotransferfolie nach einem der Ansprüche 1 bis 14, wobei das Polymer eine Ceiling-Temperatur im Schmelzpunktbereich für alle Komponenten zwischen 80 und 150°C aufweist.

16. Thermotransferfolie nach einem der Ansprüche 1 bis 15, wobei die gegebenenfalls vorliegende Benetzungshilfe iii) ausgewählt ist aus organischen Lösemitteln, die in der Lage sind, die Komponente ii) zu lösen.

17. Thermotransferfolie nach Anspruch 16, wobei das Lösemittel ein Keton, insbesondere Methylethylketon, ist.

18. Thermotransferfolie nach Anspruch 16 oder 17, wobei das Lösemittel in einer Menge enthalten ist, die ausreicht, damit nach Übertragung des Polymers der Donorschicht auf die Druckform bei einem Fixierschritt unter Wärmeeinwirkung über den Zeitraum der Wärmeeinwirkung die Verdampfung des Lösemittels zu einer intrinsischen Temperaturregelung führt.

19. Thermotransferfolie nach einem der Ansprüche 1 - 19, wobei dem Polymer der Donorschicht gemäß Anspruch 1 b) ii) 7-12 % reaktionsfähiges Polymer, bezogen auf den Gesamtpolymergehalt, zugesetzt wurden.

20. Thermotransferfolie nach Anspruch 1 - 19, wobei das reaktionsfähige Polymer vorzugsweise festes Polymer ist.

21. Thermotransferfolie nach Anspruch 20, wobei das Epoxid ein Festharz auf Basis von Bisphenol A ist.

22. Thermotransferfolie nach Anspruch 20, wobei das Isocyanat ein blockiertes Isocyanat, ein Polyester mit Uretdiongruppen, ein Dimethylpyrrol-blockiertes IPDI, ein 2-Butanonoxim-blockiertes IPDI, aromatisches Polyisocyanat oder monomeres aliphatisches Diisocyanat ist.

23. Thermotransferfolie nach einem der Ansprüche 1 bis 22, wobei der Polymermasse 1-20 %, vorzugsweise 7-12 % eines einwertigen Alkohols oder mehrwertigen Alkohols, Kohlenhydrats, eines teilweise veretherten Produkts davon oder Benzoats zugesetzt wurden.

24. Thermotransferfolie nach einem der Ansprüche 1 bis 23 in Form eines Bandes mit einer Breite im Bereich von 3 mm bis 50 mm.

25. Verfahren zur Herstellung einer Thermotransferfolie nach einem der Ansprüche 1 bis 23 oder eines Thermotransferbandes nach Anspruch 24, wobei ein Stoff i), ein Polymer ii), und gegebenenfalls eine Benetzungshilfe iii), gemäß Anspruch 1, sowie ein Lösemittel, wobei letztere identisch sein können, sorgfältig und homogen vermischt werden, die Masse dann mit einem Meyer-Bar oder nach dem Gravurverfahren auf eine Substratschicht aufgetragen wird, wobei die Dicke der Übertragungsschicht 0,5 bis 5 µm Trockendicke beträgt, und danach das Lösemittel bis zur wesentlichen Verfestigung der aufgetragenen Masse verdampft wird.

26. Masse der Donorschicht gemäß Anspruch 1, umfassend
i) einen Stoff, der die Strahlungsenergie von auftreffendem Laserlicht in Wärmeenergie umwandeln kann,
ii) ein Polymer, das saure Gruppen und/oder deren gegebenenfalls substituierte Amidgruppen umfasst, sich bei einem pH-Wert größer 10 in Wasser aber nicht im Feuchtwasser, das normalerweise beim Offset-Papierdruck verwendet wird, löst, wobei dem Polymer 1-20 % reaktionsfähiges Polymer, bezogen auf den Gesamtpolymergehalt, ausgewählt aus Epoxid, Isocyanat und/oder Polyvinylbutyral, zugesetzt wurden und
iii) gegebenenfalls eine Benetzungshilfe.

27. Druckform, die durch laserinduzierte Übertragung mit einer Masse nach Anspruch 26 bebildert ist.

28. Druckform nach Anspruch 27, die aus plasma- oder flammgespritzten Keramiken und/oder Metalloberflächen, wie Chrom, Messing (Cu52-65% Zn48-35%, und/oder Edelstählen im Sinne von hochlegierten Stählen (nach DIN17440: 1.43xx (xx=01, 10, ...), 1.4568, 1.44xx (xx=04, 35, 01 ...)) gefertigt ist.

## Claims

1. Thermal transfer film comprising a substrate layer and a donor layer applied thereto, **characterized in that**
a) the substrate layer is composed of at least one polymer material that has at least the following properties:
mechanical stability at a temperature > 150°C; transmission > 70% for light having a wavelength of 700 to 1600 nm, the substrate layer having a thickness of 50 µm to 4 µm, a tensile strength at break greater than 200 N/mm² in the machine direction and greater than 180 N/mm² in the transverse direction and a thermal shrinkage at 150°C of less than 8%;
b) the donor layer comprises at least the following components:
i) a substance that can convert the radiation energy of incident laser light into heat energy,
ii) a polymer that comprises acidic groups and/or their optionally substituted amide groups and dissolves in water at a pH greater than 10, but not in fountain water that is normally used in offset paper printing, wherein 1-20% reactive polymer, referred to the total polymer content, selected from epoxide, isocyanate and/or polyvinylbutyral are added to the polymer, and
iii) optionally a wetting agent.

2. Thermal transfer film according to Claim 1, wherein the substrate layer has a tensile strength at break of greater than 270 N/mm² in the machine direction and a thermal shrinkage at 150°C of less than 5%.

3. Thermal transfer film according to Claim 1 or 2, wherein the polymer material is a polyester, a polyarylether ether ketone, a polyphenylene ether and/or a polycarbonate.

4. Thermal transfer film according to Claim 3, wherein the polyester is selected from polyesters that are derived from dicarboxylic acids and dioles and/or from hydroxycarboxylic acids or the corresponding lactones; such as polyethylene terephthalate, polybutylene terephthalate, poly-1,4-dimethylolcyclohexane terephthalate, polyhydroxybenzoates and polyethylene naphthaline dicarboxylates; and also block copolyether esters derived from polyethers containing hydroxyl groups and polyesters modified with polycarbonates.

5. Thermal transfer film according to Claim 4, wherein the polyester is a polyethylene terephthalate.

6. Thermal transfer film according to any one of Claims 1 to 5, wherein the component i) is
a) an organic dye or an organic colouring agent having at least the properties below:
aa) an absorption maximum in the wavelength range from 700 to 1600 nm,
ab) a thermal stability greater than 150°C and/or
b) an inorganic substance that can convert radiation energy into heat energy without decomposing,
and/or
c) a type of carbon.

7. Thermal transfer film according to Claim 6, wherein the organic dye or the organic colouring agent comprises thermally stable organic dyes or pigments selected from benzothazoles, quinolines, cyanine dyes or pigments, perylene dyes or pigments, and polymethine dyes or pigments, such as oxonol dyes and pigments, or merocyanine dyes and pigments.

8. Thermal transfer film according to Claim 6, wherein the inorganic dye or the inorganic pigment is selected from TiO₂, Al₂O₃, magnetite Fe₃O₄; black spinel:
Cu(Cr,Fe)₂O₄, Co(Cr,Fe)₂O₄ and manganese ferrite MnFe₂O₄.

9. Thermal transfer film according to Claim 6, wherein the carbon is selected from a soot having a mean particle size of 5 to 100 nm.

10. Thermal transfer film according to Claim 9, wherein the soot has a DIN 55979 black index of between 200 and 290.

11. Thermal transfer film according to any one of Claims 1 to 10, wherein the polymer ii) comprises acidic groups selected from -COOH, -SO₃H, -OSO₃H and -OPO₃H₂ and/or optionally the amide groups thereof substituted with C₁-C₆-alkyl or C₆-C₁₀-aryl radicals.

12. Thermal transfer film according to any one of Claims 1 to 11, wherein the polymer has a number average of the molecular weight of 1000 to 20,000.

13. Thermal transfer film according to any one of Claims 1 to 12, wherein the polymer applied has a surface tension of 50 to 20 mN/m determined by wetting-angle measurement.

14. Thermal transfer film according to any one of Claims 1 to 13, wherein the polymer has a glass transition temperature in the range from 30 to 100°C.

15. Thermal transfer film according to any one of Claims 1 to 14, wherein the polymer has a ceiling temperature in the melting point range for all the components of between 80 and 150°C.

16. Thermal transfer film according to any one of Claims 1 to 15, wherein the wetting agent iii) optionally present is selected from organic solvents that are capable of dissolving the component ii).

17. Thermal transfer film according to Claim 16, wherein the solvent is a ketone, in particular methyl ethyl ketone.

18. Thermal transfer film according to Claim 16 or 17, wherein the solvent is contained in an amount that is sufficient for the evaporation of the solvent by heat action during the time period of the heat action in an intrinsic temperature regulation after transfer of the polymer of the donor layer to the printing forme in a fixation step.

19. Thermal transfer film according to any one of Claims 1-19, wherein, in accordance with Claim 1 b) ii) 7-12% reactive polymer, referred to the total polymer content, was added to the polymer of the donor layer.

20. Thermal transfer film according to Claims 1-19, wherein the reactive polymer is preferably a solid polymer.

21. Thermal transfer film according to Claim 20, wherein the epoxide is a solid resin based on bisphenol A.

22. Thermal transfer film according to Claim 20, wherein the isocyanate is a blocked isocyanate, a polyester containing uretdione groups, a dimethylpyrrol-blocked IPDI, a 2-butanoneoxim-blocked IPDI, an aromatic polyisocyanate or a monomeric aliphatic diisocyanate.

23. Thermal transfer film according to any one of Claims 1 to 22, wherein 1-20%, preferably 7-12% of a monohydric alcohol or a polyhydric alcohol, carbohydrate, a partially etherified product thereof or a benzoate is added to the polymer material.

24. Thermal transfer film according to any one of Claims 1 to 23 in the form of a strip having a width in the range from 3 mm to 50 mm.

25. Method of producing a thermal transfer film according to any one of Claims 1 to 23 or a thermal transfer strip according to Claim 24, wherein a substance i), a polymer ii) and optionally a wetting aid iii), in accordance with Claim 1, and also a solvent, wherein the latter may be identical, are carefully and homogeneously blended, the material is then applied using a Meyer bar or by the gravure method to a substrate layer, wherein the thickness of the transfer layer is 0.5 to 5 µm dry thickness and then the solvent is evaporated until the applied material is essentially solidified.

26. Material of the donor layer in accordance with Claim 1, comprising
i) a substance that can convert the radiation energy of the incident laser light into heat energy,
ii) a polymer that comprises acidic groups and/or their optionally substituted amide groups and dissolves in water at a pH greater than 10, but not in fountain water that is normally used in offset paper printing, wherein 1-20% reactive polymer, referred to the total polymer content, selected from epoxy, isocyanate and/or polyvinylbutyral are added to the polymer, and
iii) optionally a wetting aid.

27. Printing forme that is patterned by laser-induced transfer using a material according to Claim 26.

28. Printing forme according to Claim 27 that is manufactured from plasma- or flame-sprayed ceramics and/or metal surfaces, such as chromium, brass (Cu52-65% Zn48-35%) and/or stainless steels in the sense of highly alloyed steels (according to DIN 17440: 1.43xx (xx=01, 10, ...), 1.4568, 1.44xx (xx=04, 35, 01 ...)).

## Revendications

1. Feuille de transfert thermique, comprenant une couche de substrat et une couche donneuse disposée sur celui-ci,
**caractérisée en ce que**
a) la couche de substrat est constituée d'au moins un polymère en masse qui présente au moins les propriétés suivantes :
stabilité mécanique à une température > 150°C ; transmission > 70 % pour la lumière de la longueur d'ondes de 700 à 1 600 nm, la couche de substrat ayant une épaisseur de 50 µm à 4 µm, une résistance à la traction en cas de rupture supérieure à 200 N/mm² dans la direction de la machine et supérieure à 180 N/mm² dans la direction transversale et une contraction thermique inférieure à 8 % sous 150°C ;
b) la couche donneuse comprend au moins les composants suivants :
i) une substance pouvant transformer l'énergie de rayonnement émise par la lumière laser en une énergie thermique ;
ii) un polymère, comprenant des groupes acides et/ ou leurs groupes amides substitués le cas échéant, qui se dissout dans l'eau, mais pas dans la solution de mouillage qui est normalement utilisée pour l'imprimerie offset, pour une valeur pH supérieure à 10, en ajoutant au polymère 1 à 20 % de polymère réactif par rapport à la teneur totale du polymère choisi parmi l'époxyde, l'isocyanate et/ ou le polyvinyle butyral, et
iii) le cas échéant un agent de mouillage.

2. Feuille de transfert thermique selon la revendication 1,
dans laquelle
la couche de substrat présente une résistance à la traction en cas de rupture supérieure à 270 N/mm² dans la direction de la machine et une contraction thermique inférieure à 5 % sous 150°C.

3. Feuille de transfert thermique selon la revendication 1 ou 2,
dans laquelle
le polymère est composé d'un polyester, d'une polyaryléthercétone, d'un polyphénylènéther et/ou d'un polycarbonate.

4. Feuille de transfert thermique selon la revendication 3,
dans laquelle
le polyester est choisi parmi des polyesters dérivés des acides dicarboxyliques et des diols et/ou des acides hydroxycarboxyliques ou des lactones correspondants, tels que le polyéthylènetéréphthalate, le poly-butylènetéréphtalate, le poly-1,4-diméthylolcyclo-hexanetéréphtalate, le polyhydroxybenzoate et le polyéthylènenaphthalinedicarboxylate ; ainsi que des blocs copolyéther-esters, dérivés des polyéthers avec des groupes hydroxylènes et des polyesters modifiés par polycarbonates.

5. Feuille de transfert thermique selon la revendication 4,
dans laquelle
le polyester est un polyéthylènetéréphtalate.

6. Feuille de transfert thermique selon l'une des revendications 1 à 5,
dans laquelle
le composant i) est :
a) un colorant organique ou une teinture organique présentant au moins les propriétés suivantes :
aa) un maximum d'absorption dans le domaine de longueurs d'ondes compris entre 700 et 1 600 nm,
ab) une résistance à la chaleur supérieure à 150°C,
et/ ou
b) une substance anorganique qui peut transformer l'énergie de rayonnement en une énergie thermique, sans se décomposer,
et/ ou
c) un type de carbone.

7. Feuille de transfert thermique selon la revendication 6,
dans laquelle
le colorant organique ou la teinture organique comprend des colorants ou pigments organiques choisis parmi les benzothiazoles, chinolines, colorants ou pigments de cyanine, colorants ou pigments de pérylène et colorants ou pigments de polyméthine, comme les colorants ou pigments d'oxonol et les colorants ou pigments de mérocyanine.

8. Feuille de transfert thermique selon la revendication 6,
dans laquelle
le colorant organique ou le pigment organique est choisi parmi TiO₂, Al₂O₃, magnétite Fe₃O₄, spinelle noir : Cu(Cr,Fe)₂O₄, Co(Cr,Fe)₂O₄ et ferrite de manganèse MnFe₂O₄.

9. Feuille de transfert thermique selon la revendication 6,
dans laquelle
le carbone est choisi à partir d'un noir ayant une grosseur de particule moyenne comprise entre 5 et 100 nm.

10. Feuille de transfert thermique selon la revendication 9,
dans laquelle
le noir présente un indice de noir compris entre 200 et 290 selon DIN 55979.

11. Feuille de transfert thermique selon l'une des revendications 1 à 10,
dans laquelle
le polymère ii) présente des groupes acides, choisis parmi -COOH, - SO₃H, -OSO₃H et -OPO₃H₂ et/ou le cas échéant les groupes amides substitués par radicaux alkyles en C₁-C₆ ou aryles en C₆-C₁₀.

12. Feuille de transfert thermique selon l'une des revendications 1 à 11,
dans laquelle
le polymère présente une moyenne numérique de masse moléculaire comprise entre 1 000 et 20 000.

13. Feuille de transfert thermique selon l'une des revendications 1 à 12,
dans laquelle
le polymère déposé présente une contrainte surfacique de 50 à 20 mN/m, déterminée par une mesure des angles de contact.

14. Feuille de transfert thermique selon l'une des revendications 1 à 13,
dans laquelle
le polymère présente une température de transition vitreuse dans la plage comprise entre 30 et 100°C.

15. Feuille de transfert thermique selon l'une des revendications 1 à 14,
dans laquelle
le polymère présente une température plafond dans le domaine du point de fusion comprise entre 80 et 150°C pour tous les composants.

16. Feuille de transfert thermique selon l'une des revendications 1 à 15,
dans laquelle
l'agent de mouillage iii) présent le cas échéant est choisi parmi des solvants organiques capables de dissoudre le composant ii).

17. Feuille de transfert thermique selon la revendication 16,
dans laquelle
le solvant est une cétone, notamment une méthyléthylcétone.

18. Feuille de transfert thermique selon la revendication 16 ou 17,
dans laquelle
le solvant est contenu en quantité suffisante pour pouvoir, après le transfert du polymère de la couche donneuse sur la plaque d'impression au cours d'une étape de fixation sous l'action de la chaleur, effectuer l'évaporation du solvant pendant la durée de l'action de la chaleur à une température régulée intrinsèquement.

19. Feuille de transfert thermique selon l'une des revendications 1 à 19,
dans laquelle
7 à 12 % de polymère réactif, par rapport à la teneur totale du polymère, sont ajoutés au polymère de la couche donneuse selon la revendication 1 b) ii).

20. Feuille de transfert thermique selon l'une des revendications 1 à 19,
dans laquelle
le polymère réactif est de préférence un polymère solide.

21. Feuille de transfert thermique selon la revendication 20,
dans laquelle
l'époxyde est une résine solide à base de bisphénol A.

22. Feuille de transfert thermique selon la revendication 20,
dans laquelle
l'isocyanate est un isocyanate bloqué, un polyester avec des groupes uretdion, un IPDI bloqué par diméthylepyrrol, un IPDI bloqué par 2-butanoxime, un polyisocyanate aromatique ou un diisocyanate aliphatique monomère.

23. Feuille de transfert thermique selon l'une des revendications 1 à 22,
dans laquelle
on ajoute au polymère en masse 1 à 20 %, de préférence 7 à 12 % d'un alcool monovalent ou d'un alcool plurivalent, d'un hydrate de carbone, d'un de ces produits partiellement éthérifiés ou d'un benzoate.

24. Feuille de transfert thermique selon l'une des revendications 1 à 23,
ayant la forme d'une bande dont la largeur est dans la plage comprise entre 3 mm et 50 mm.

25. Procédé de fabrication d'une feuille de transfert thermique selon l'une des revendications 1 à 23 ou d'une bande de transfert thermique selon la revendication 24,
dans lequel
une substance i), un polymère ii), et le cas échéant un agent de mouillage iii) selon la revendication 1, ainsi qu'un solvant, ces derniers pouvant être identiques, sont mélangés avec soin et de manière homogène, la composition étant ensuite déposée sur une couche de substrat au moyen d'une barre de Meyer ou au moyen d'un procédé de gravure, l'épaisseur de la couche de transfert ayant de 0,5 à 5 µm d'épaisseur sèche, et ensuite le solvant est évaporé sur la composition déposée jusqu'à obtenir une solidification essentielle.

26. Composition de la couche donneuse selon la revendication 1, comprenant :
i) une substance qui peut transformer l'énergie de rayonnement émise par la lumière laser en une énergie thermique,
ii) un polymère, comprenant des groupes acides et/ou leurs groupes amides substitués le cas échéant, qui se dissout dans l'eau, mais pas dans la solution de mouillage, qui est normalement utilisée pour l'imprimerie offset, avec une valeur pH supérieure à 10, en ajoutant au polymère 1 à 20 % du polymère réactif par rapport à la teneur totale du polymère, choisi parmi l'époxyde, l'isocyanate et/ ou le polyvinyle butyral, et
iii) le cas échéant un agent de mouillage.

27. Plaque d'impression qui est formée avec une composition selon la revendication 26 au moyen d'un transfert induit par laser.

28. Plaque d'impression selon la revendication 27, fabriquée à partir de céramiques pulvérisées par plasma ou par flammes et/ou de surfaces métalliques comme le chrome, le laiton (à 52-65 % de Cu, 48-35 % de Zn et/ou d'aciers nobles dans le sens d'aciers à alliages élevés (selon DIN 17440 : 1.43xx (xx = 01, 10...), 1.4568, 1.44xx (xx = 04, 35, 01...)).
